(19) **Europäisches Patentamt / European Patent Office / Office européen des brevets**

(11) **EP 3 259 606 B1**

(12) # FASCICULE DE BREVET EUROPEEN

(45) Date de publication et mention de la délivrance du brevet:
**26.12.2018 Bulletin 2018/52**

(21) Numéro de dépôt: **16707910.2**

(22) Date de dépôt: **12.02.2016**

(51) Int Cl.:
**G01R 23/167** *(2006.01)* **H04J 1/12** *(2006.01)*
**H04B 17/309** *(2015.01)*

(86) Numéro de dépôt international:
**PCT/FR2016/050323**

(87) Numéro de publication internationale:
**WO 2016/132050 (25.08.2016 Gazette 2016/34)**

(54) **PROCÉDÉ ET SYSTÈME DE DÉTECTION DE SIGNAUX UTILES À DÉRIVES FRÉQUENTIELLES RESPECTIVES NON NÉGLIGEABLES DANS UN SIGNAL GLOBAL**

VERFAHREN UND SYSTEM ZUR ERKENNUNG VON NÜTZLICHEN SIGNALEN MIT ENTSPRECHENDEM UNVERNACHLÄSSIGBAREN FREQUENZDRIFT IN EINEM GESAMTSIGNAL

METHOD AND SYSTEM FOR DETECTING USEFUL SIGNALS, WITH RESPECTIVE NON-NEGLIGIBLE FREQUENCY DRIFT, IN A TOTAL SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.02.2015 FR 1551360**

(43) Date de publication de la demande:
**27.12.2017 Bulletin 2017/52**

(73) Titulaire: **Airbus Defence and Space SAS**
**31402 Toulouse Cedex 4 (FR)**

(72) Inventeurs:
- **PICARD, Mathieu**
 **31402 Toulouse Cedex 4 (FR)**
- **ANTEUR, Mehdi**
 **31402 Toulouse Cedex 4 (FR)**

(74) Mandataire: **Ipside**
**6, Impasse Michel Labrousse**
**31100 Toulouse (FR)**

(56) Documents cités:
**WO-A1-2014/006351    US-B1- 7 787 846**

**Description**

## DOMAINE TECHNIQUE

La présente invention appartient au domaine de la détection de signaux utiles émis par différents terminaux. Plus particulièrement, la présente invention concerne la détection de signaux utiles dans le cas où chaque signal utile est de durée finie et peut être affecté d'une dérive fréquentielle supérieure, sur la durée dudit signal utile, à une largeur spectrale dudit signal utile.

Par « largeur spectrale » du signal utile, on entend la largeur du spectre fréquentiel instantané du signal utile. La largeur spectrale dudit signal utile est donc indépendante de la dérive fréquentielle.

## ÉTAT DE LA TECHNIQUE

La présente invention trouve une application particulièrement avantageuse, bien que nullement limitative, dans le cas de signaux utiles dits à « bande étroite » pour lesquels la largeur spectrale est inférieure à 1 kilohertz.

Dans le cas de signaux utiles à bande étroite, de nombreux phénomènes peuvent introduire une dérive fréquentielle supérieure à la largeur spectrale desdits signaux utiles.

Tout d'abord, les signaux utiles étant reçus par une station de réception, des déplacements relatifs des terminaux par rapport à ladite station de réception peuvent induire, par effet Doppler, des dérives fréquentielles qui peuvent s'avérer non négligeables par rapport à la largeur spectrale des signaux utiles si les vitesses relatives de déplacement sont importantes. De telles dérives fréquentielles peuvent être introduites du fait d'une mobilité des terminaux et/ou d'une mobilité de la station de réception.

Notamment, dans le cas d'une station de réception embarquée dans un satellite en orbite défilante, par exemple une orbite basse LEO, la vitesse de défilement dudit satellite par rapport aux terminaux (fixes ou mobiles) peut introduire des dérives fréquentielles non négligeables des signaux utiles reçus au niveau de ladite station de réception.

La dérive fréquentielle peut également être introduite dès l'émission, de manière non contrôlée. En effet, l'émission d'un signal utile nécessite d'équiper un terminal de moyens de synthèse fréquentielle (oscillateur local, mélangeur, etc.) mis en oeuvre pour translater fréquentiellement le signal utile, généré en bande de base, vers une bande fréquentielle de multiplexage des signaux utiles. De tels moyens de synthèse fréquentielle introduisent une dérive fréquentielle qui, dans le cas notamment de signaux utiles à bande étroite, peut s'avérer non négligeable par rapport à la largeur spectrale desdits signaux utiles, en particulier dans le cas de terminaux bas coût pour lesquels les moyens de synthèse fréquentielle sont peu performants (voir par exemple WO 2014/006351 A1 et US 7,787,846 B1). Cependant, la dérive fréquentielle introduite par les moyens de synthèse fréquentielle est négligeable au regard de celle engendrée par les déplacements relatifs des terminaux par rapport à la station de réception, en particulier sur une période courte telle que la durée d'un message.

Dans une moindre mesure, les moyens de synthèse fréquentielle de la station de réception peuvent également introduire une dérive fréquentielle, mais celle-ci est, à chaque instant, sensiblement la même pour tous les signaux utiles.

En outre, certains signaux utiles peuvent être émis intentionnellement avec une dérive fréquentielle. C'est le cas notamment des « chirps ». De manière connue de l'homme du métier, un « chirp » est un signal pseudopériodique, continu ou discontinu, dont la fréquence augmente (ou diminue) au cours du temps, généralement de façon sensiblement linéaire. Ainsi, on peut distinguer différents types de dérives fréquentielles :

- des dérives fréquentielles résultantes de l'émission des signaux utiles, intentionnelles (par exemple un « chirp ») ou non intentionnelles (par exemple du fait de moyens de synthèse fréquentielle peu performants),
- des dérives fréquentielles indépendantes de l'émission des signaux utiles, ressenties uniquement au niveau de la station de réception (par exemple par effet Doppler).

La détection de tels signaux utiles est complexe à effectuer, et ce d'autant plus que la dérive fréquentielle peut varier d'un signal utile à un autre. En outre, la fréquence initiale et l'instant d'émission de chaque signal utile ne sont pas nécessairement connus, ce qui rend la détection des signaux utiles encore plus complexe, puisqu'ils doivent être détectés de façon aveugle ou quasi-aveugle sans connaître a priori les dérives fréquentielles, les instants d'émission et les fréquences initiales respectifs desdits signaux utiles.

Il est possible de mettre en oeuvre des estimateurs au sens du maximum de vraisemblance, en testant toutes les possibilités possibles. Toutefois, la quantité de calculs et de quantité de données à mémoriser est alors très importante, et peut s'avérer dans certains cas rédhibitoire, en particulier pour la détection de signaux utiles au niveau d'un satellite.

## EXPOSÉ DE L'INVENTION

La présente invention a pour objectif de remédier à tout ou partie des limitations des solutions de l'art antérieur, notamment celles exposées ci-avant, en proposant une solution qui permette de détecter des signaux utiles dans un signal global, lesdits signaux utiles pouvant être affectés de dérives fréquentielles de valeurs respectives différentes.

A cet effet, et selon un premier aspect, l'invention concerne un procédé de détection d'une pluralité de signaux utiles dans un signal global, chaque signal utile étant de durée finie et pouvant être affecté d'une dérive fréquentielle supérieure, sur la durée dudit signal utile, à une largeur spectrale dudit signal utile, lesdits signaux utiles correspondant à des signaux radioélectriques émis par différents terminaux dans une bande fréquentielle de multiplexage, ledit signal global correspondant à l'ensemble des signaux radioélectriques reçus dans la bande fréquentielle de multiplexage. Le procédé de détection de signaux utiles comporte des étapes :

- calcul de plusieurs spectrogrammes associés respectivement à différentes valeurs de dérive fréquentielle linéaire, chaque spectrogramme étant représentatif des valeurs du spectre fréquentiel du signal global à différentes fréquences d'analyse dans la bande fréquentielle de multiplexage, et des évolutions dans le temps desdites valeurs du spectre fréquentiel à différents instants d'analyse à l'intérieur d'une fenêtre temporelle d'analyse en compensant la dérive fréquentielle linéaire considérée,
- pour chaque fréquence d'analyse et chaque spectrogramme : filtrage d'enveloppe temporelle des valeurs aux différents instants d'analyse dudit spectrogramme à ladite fréquence d'analyse, au moyen d'un filtre représentatif d'une enveloppe temporelle de référence des signaux utiles,

un signal utile étant détecté à un instant d'analyse et une fréquence d'analyse si un critère prédéfini de détection est vérifié par la valeur d'un spectrogramme obtenu par filtrage, dit « spectrogramme filtré », pour ledit instant d'analyse et ladite fréquence d'analyse.

La présente invention repose par conséquent sur le calcul de spectrogrammes associés respectivement à différentes valeurs de dérive fréquentielle linéaire, dans lesquels la dérive fréquentielle linéaire pour chaque valeur considérée a été compensée.

En faisant l'hypothèse que les dérives fréquentielles affectant les signaux utiles sont linéaires, c'est-à-dire de dérivée première constante, les calculs à effectuer sont facilités et réduits. Si cette hypothèse peut dans certains cas être bien vérifiée pour des « chirps », il s'agit cependant d'une approximation pour les autres types de signaux utiles. En outre, la complexité de calcul peut être ajustée par un choix d'un nombre plus ou moins important de valeurs différentes de la dérive fréquentielle linéaire, la détection étant toutefois plus robuste et plus précise lorsque ce nombre est important.

Un spectrogramme obtenu pour une valeur particulière de dérive fréquentielle linéaire correspond à un ensemble de valeurs du spectre fréquentiel du signal global, sur lequel la dérive fréquentielle linéaire considérée a été compensée, obtenues pour différentes fréquences d'analyse à l'intérieur de la bande fréquentielle de multiplexage et pour différents instants d'analyse à l'intérieur de la fenêtre temporelle d'analyse. Là encore, la complexité de calcul peut être ajustée par un choix d'un nombre plus ou moins important de fréquences d'analyse et/ou d'instants d'analyse, dans la limite toutefois que l'écart entre les fréquences d'analyse est de préférence égal ou inférieur à la largeur spectrale minimale desdits signaux utiles, et que l'écart entre les instants d'analyse est de préférence égal ou inférieur à la durée minimale desdits signaux utiles.

Un signal utile présentant une dérive fréquentielle sensiblement linéaire de valeur $\Delta F$ (exprimée en hertz par seconde) aura donc, dans le spectrogramme associé à la dérive fréquentielle linéaire de valeur $\Delta F$, une fréquence centrale sensiblement constante. Ainsi, dans chaque spectrogramme calculé, la détection consiste avantageusement en une recherche de signaux utiles dépourvus de dérive fréquentielle.

Le procédé de détection comporte également un filtrage d'enveloppe temporelle des différentes valeurs du spectrogramme suivant l'axe temporel. Cette étape vise à améliorer en chaque instant d'analyse le rapport signal sur bruit d'un éventuel signal utile dépourvu de dérive fréquentielle, en tenant compte d'une connaissance a priori sur l'enveloppe temporelle des signaux utiles, par exemple sur la durée desdits signaux utiles ou la durée minimale des signaux utiles s'ils n'ont pas la même durée et/ou s'ils sont de durée variable.

Dans des modes particuliers de mise en oeuvre, le procédé de détection peut en outre comporter l'une ou plusieurs des caractéristiques suivantes, prises isolément ou selon toutes les combinaisons techniquement possibles.

Dans des modes particuliers de mise en oeuvre, le procédé de détection comporte, pour chaque instant d'analyse et chaque spectrogramme, une étape de filtrage de spectre fréquentiel des valeurs aux différentes fréquences d'analyse dudit spectrogramme audit instant d'analyse, au moyen d'un filtre représentatif d'un spectre fréquentiel de référence des signaux utiles.

De telles dispositions permettent d'améliorer en chaque fréquence d'analyse le rapport signal sur bruit d'un éventuel signal utile en tenant compte d'une connaissance a priori sur le spectre fréquentiel desdits signaux utiles, par exemple sur la largeur spectrale desdits signaux utiles ou la largeur spectrale minimale desdits signaux utiles s'ils n'ont pas la même largeur spectrale et/ou s'ils sont de largeur spectrale variable.

Dans des modes particuliers de mise en oeuvre, l'étape de filtrage d'enveloppe temporelle et l'étape de filtrage de spectre fréquentiel sont exécutées conjointement.

Dans des modes particuliers de mise en oeuvre, le procédé de détection comporte une étape de recherche de maxima locaux sur un ensemble à trois dimensions constitué par les valeurs des différents spectrogrammes filtrés, le critère de détection étant évalué pour des valeurs correspondant à des maxima locaux dudit ensemble.

Dans des modes particuliers de mise en oeuvre, l'étape de recherche de maxima locaux comporte :

- l'établissement d'une carte de détection associant, à chaque fréquence d'analyse et chaque spectrogramme filtré, la valeur maximale dudit spectrogramme filtré à ladite fréquence d'analyse sur les instants d'analyse de la fenêtre temporelle d'analyse,
- la recherche de maxima locaux de ladite carte de détection, le critère de détection étant évalué pour des valeurs correspondant à des maxima locaux de ladite carte de détection.

De telles dispositions sont avantageuses en ce qu'elles permettent de réduire la complexité de calcul associée à la recherche de maxima locaux.

Dans des modes particuliers de mise en oeuvre, le critère de détection est vérifié pour une valeur d'un spectrogramme filtré si ladite valeur est supérieure à une valeur seuil prédéfinie.

Dans des modes particuliers de mise en oeuvre, le critère de détection est vérifié pour une valeur d'un spectrogramme filtré si ladite valeur est une valeur maximale sur une fenêtre fréquentielle de détection prédéfinie autour de la fréquence d'analyse à laquelle ladite valeur a été obtenue.

Dans des modes particuliers de mise en oeuvre, le critère de détection est vérifié pour une valeur d'un spectrogramme filtré si l'instant d'analyse auquel ladite valeur a été obtenue se trouve dans une portion centrale prédéfinie de la fenêtre temporelle d'analyse.

Dans des modes particuliers de mise en oeuvre, le calcul d'un spectrogramme associé à une valeur de dérive fréquentielle linéaire comporte des calculs de transformée de Fourier fractionnaire de blocs successifs du signal global, d'angle correspondant à la dérive fréquentielle linéaire considérée.

Dans des modes particuliers de mise en oeuvre, le calcul d'un spectrogramme associé à une valeur de dérive fréquentielle linéaire comporte une compensation préalable de la dérive fréquentielle linéaire considérée sur le signal global, et des calculs de transformée de Fourier de blocs successifs du signal global obtenu après compensation.

Dans des modes particuliers de mise en oeuvre, le calcul d'un spectrogramme associé à une valeur de dérive fréquentielle linéaire comporte des calculs de transformée de Fourier de blocs successifs du signal global, et une compensation de la dérive fréquentielle linéaire considérée sur les spectres fréquentiels des blocs successifs.

Dans des modes particuliers de mise en oeuvre, les étapes dudit procédé sont itérées pour des fenêtres temporelles d'analyse successives présentant un recouvrement temporel non nul.

Selon un second aspect, la présente invention concerne un produit programme d'ordinateur comportant un ensemble d'instructions de code de programme qui, lorsqu'elles sont exécutées par un processeur, configurent ledit processeur pour mettre en oeuvre un procédé de détection de signaux utiles selon l'un quelconque des modes de mise en oeuvre de l'invention.

Selon un troisième aspect, la présente invention concerne un module de détection de signaux utiles dans un signal global, comportant des moyens configurés pour mettre en oeuvre un procédé selon l'un quelconque des modes de mise en oeuvre de l'invention.

Selon un quatrième aspect, la présente invention concerne un système de détection de signaux utiles dans un signal global, comportant une antenne de réception du signal global embarquée dans un engin spatial ou aérien, et comportent un module de détection selon l'un quelconque des modes de mise en oeuvre de l'invention.

## PRÉSENTATION DES FIGURES

L'invention sera mieux comprise à la lecture de la description suivante, donnée à titre d'exemple nullement limitatif, et faite en se référant aux figures qui représentent :

- Figure 1 : une représentation schématique d'un exemple de réalisation d'un système de détection de signaux utiles,
- Figure 2 : un diagramme représentant les principales étapes d'un procédé de détection de signaux utiles selon l'invention,
- Figure 3 : des représentations schématiques de spectrogrammes d'un signal global, associés respectivement à différentes valeurs de dérive fréquentielle linéaire,

- Figure 4 : un diagramme représentant les principales étapes d'un procédé de détection selon un mode particulier de mise en oeuvre,

- Figure 5 : un diagramme représentant un mode préféré de mise en oeuvre d'une étape de recherche de signaux utiles du procédé de détection.

Dans ces figures, des références identiques d'une figure à une autre désignent des éléments identiques ou analogues. Pour des raisons de clarté, les éléments représentés ne sont pas à l'échelle, sauf mention contraire.

## DESCRIPTION DÉTAILLÉE DE MODES DE RÉALISATION

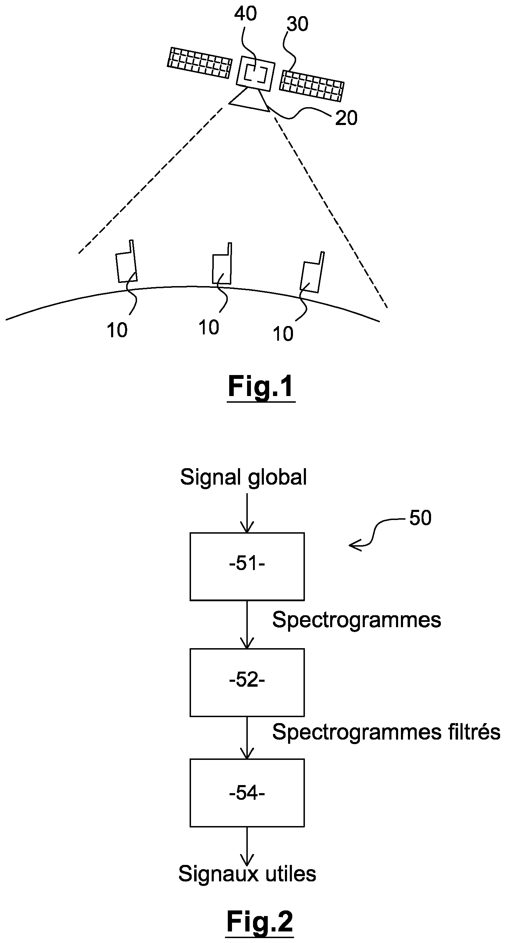

La figure 1 représente schématiquement un exemple de réalisation d'un système de détection de signaux utiles. Les signaux utiles correspondent à des signaux radioélectriques émis dans une bande fréquentielle de multiplexage par des terminaux 10 sensiblement à la surface de la Terre. Par « sensiblement à la surface de la Terre », on entend que chaque terminal 10 est au sol (terrestre ou maritime), ou bien en altitude dans l'atmosphère terrestre (embarqué dans un avion, un drone, un ballon, etc.).

Plus particulièrement, les signaux utiles doivent être détectés dans un signal global, reçu par une station de réception 20, représentatif de l'ensemble des signaux radioélectriques reçus dans la bande fréquentielle de multiplexage. Il est à noter que l'invention est applicable dans n'importe quelle bande de fréquences, notamment les bandes de fréquences traditionnellement utilisées dans les systèmes de télécommunications terrestres ou par satellite.

Dans la suite de la description, et tel qu'illustré par la figure 1, on se place de manière non limitative dans le cas où la station de réception 20 est embarquée dans un satellite 30 en orbite terrestre. Rien n'exclut cependant, suivant d'autres exemples, d'avoir une station de réception embarquée dans un engin spatial ou aérien (avion, drone, ballon, etc.). La station de réception peut également, suivant d'autres exemples, être au sol (terrestre ou maritime).

Le satellite 30 est de préférence en orbite basse altitude LEO (« Low Earth Orbit »). Rien n'exclut cependant de considérer d'autres types d'orbites, par exemple une orbite moyenne altitude MEO (« Medium Earth Orbit »), une orbite géostationnaire GEO (« Geostationary Orbit »), etc.

Chaque terminal 10 peut être fixe ou mobile. De même, la station de réception 20 peut être fixe ou mobile.

Tel qu'indiqué précédemment, chaque signal utile reçu par la station de réception 20 est de durée finie et peut être affecté d'une dérive fréquentielle supérieure, sur la durée dudit signal utile, à la largeur spectrale dudit signal utile. Par « largeur spectrale » du signal utile, on entend la largeur du spectre fréquentiel instantané du signal utile. La dérive fréquentielle affectant un signal utile peut être inhérente audit signal utile, intentionnelle (par exemple un « chirp ») ou non intentionnelle (par exemple du fait de moyens de synthèse fréquentielle peu performants), et/ou indépendante dudit signal utile et ressentie uniquement au niveau de la station de réception 20 (par exemple par effet Doppler, du fait d'une mobilité du terminal 10 et/ou de la station de réception 20). Sur la durée dudit signal utile, la dérive fréquentielle perçue à la station de réception est majoritairement causée par la mobilité relative d'un terminal et minoritairement par la dérive des moyens de synthèse fréquentielle.

La bande fréquentielle de multiplexage est de préférence de largeur très supérieure à la largeur spectrale de chaque signal utile, par exemple au moins 100 fois supérieure à la largeur spectrale maximale des signaux utiles. Le signal global, représentatif des signaux radioélectriques reçus dans la bande fréquentielle de multiplexage, peut par conséquent comporter de nombreux signaux utiles multiplexés en fréquences dans ladite bande fréquentielle de multiplexage. En outre, les signaux utiles étant de durée finie, le signal global peut également comporter de nombreux signaux utiles multiplexés répartis au cours du temps. Dans la suite de la description, on se place dans le cas où l'on ne connaît pas a priori :

- les instants d'émission respectifs des signaux utiles, par exemple du fait que les terminaux peuvent émettre quand ils le souhaitent, sans autorisation préalable, ou émettent à des instants choisis aléatoirement pour réduire les risques de collision entre signaux utiles, etc.,
- les fréquences initiales respectives desdits signaux utiles, par exemple du fait que les terminaux peuvent émettre sur la fréquence qu'ils souhaitent à l'intérieur de la bande fréquentielle de multiplexage, ou ne maîtrisent pas parfaitement la fréquence sur laquelle ils émettent (par exemple du fait de moyens de synthèse fréquentielle peu performants), etc.

Dans la suite de la description, on se place de manière non limitative dans le cas où les signaux utiles sont à bande étroite, c'est-à-dire de largeur spectrale égale ou inférieure à 1 kilohertz, de préférence égale ou inférieure à 500 hertz. L'invention est également applicable pour d'autres types de signaux utiles, toutefois on comprend que, pour de tels signaux utiles, une dérive fréquentielle peut facilement devenir non négligeable.

Tel qu'illustré par la figure 1, le système de détection de signaux utiles comporte également un module 40 de détection.

Dans l'exemple non limitatif illustré par la figure 1, le module 40 de détection est embarqué dans le satellite 30. Rien n'exclut, suivant d'autres exemples, d'avoir un module 40 de détection distant du satellite 30, par exemple au niveau d'une station sol (non représentée sur les figures), ou distribué entre le satellite 30 et un ou plusieurs équipements distants dudit satellite 30. A des fins de redondance, le système de détection peut comporter un module 40 de détection embarqué à bord du satellite 30, et un autre module 40 de détection au niveau d'une ou de plusieurs stations sol.

Le module 40 de détection est adapté notamment à détecter des signaux utiles dans le signal global reçu par la station de réception 20, ledit signal global se présentant sous la forme d'une suite d'échantillons obtenus après conversion analogique / numérique d'un signal analogique fourni par ladite station de réception 20.

Le module 40 de détection comporte par exemple un ou plusieurs processeurs et des moyens de mémorisation (disque dur magnétique, mémoire électronique, disque optique, etc.) dans lesquels est mémorisé un produit programme d'ordinateur, sous la forme d'un ensemble d'instructions de code de programme à exécuter pour mettre en oeuvre les différentes étapes d'un procédé 50 de détection de signaux utiles dans le signal global. Dans une variante, le module 40 de détection comporte un ou des circuits logiques programmables, de type FPGA, PLD, etc., et/ou circuits intégrés spécialisés (ASIC) adaptés à mettre en oeuvre tout ou partie desdites étapes du procédé 50 de détection de signaux utiles.

En d'autres termes, le module 40 de détection comporte un ensemble de moyens configurés de façon logicielle (produit programme d'ordinateur spécifique) et/ou matérielle (FPGA, PLD, ASIC, etc.) pour mettre en oeuvre les différentes étapes du procédé 50 de détection de signaux utiles.

La figure 2 représente les principales étapes d'un procédé 50 de détection de signaux utiles dans le signal global, lesquelles sont :

- une étape 51 de calcul de plusieurs spectrogrammes associés respectivement à différentes valeurs de dérive fréquentielle linéaire, dans lesquels la dérive fréquentielle linéaire pour chaque valeur considérée a été compensée,
- pour chaque fréquence d'analyse et chaque spectrogramme : une étape 52 de filtrage d'enveloppe temporelle des valeurs aux différents instants d'analyse dudit spectrogramme à ladite fréquence d'analyse, au moyen d'un filtre représentatif d'une enveloppe temporelle de référence des signaux utiles,
- une étape 54 de recherche de signaux utiles dans les spectrogrammes obtenus par filtrage, désignés ci-après par « spectrogrammes filtrés ».

Au cours de l'étape 51 de calcul, les différents spectrogrammes sont calculés à partir du signal global. Tel qu'indiqué précédemment, le signal global se présente sous la forme d'une suite d'échantillons obtenus après conversion analogique / numérique d'un signal analogique fourni par la station de réception 20. Par exemple, le signal global comporte sur une fenêtre temporelle d'analyse un nombre Ne d'échantillons $x[j]$ $(0 \leq j \leq Ne-1)$ séparés par une période d'échantillonnage Te prédéfinie.

Pour calculer les différents spectrogrammes, le signal global sur la fenêtre temporelle d'analyse considérée est par exemple décomposé en K blocs $x_k$ successifs de N échantillons $(K \cdot N = Ne)$, associés respectivement à différents instants d'analyse k à l'intérieur de la fenêtre temporelle d'analyse :

$$x_k = \{x[n+k \cdot N], 0 \leq n \leq N-1\}, 0 \leq k \leq K-1$$

Les différentes valeurs de dérive fréquentielle linéaire à considérer sont par exemple choisies réparties de manière régulière dans un plage prédéfinie de valeurs, dont les bornes sont par exemple définies en fonction d'une connaissance a priori des dérives fréquentielles maximales susceptibles d'affecter les différents signaux utiles (par exemple en fonction des vitesses maximales de déplacement des terminaux 10 et de la station de réception 20, en fonction de la dérive fréquentielle maximale des moyens de synthèse fréquentielle des terminaux 10, etc.). Par exemple, on peut considérer des valeurs $\alpha_m$ de dérive fréquentielle linéaire comprises entre -500 hertz par seconde (Hz/s) et 0 Hz/s, avec un pas de 50 Hz/s :

$$\alpha_m \in \{-500, -450, \ldots, -50, 0\} \text{ Hz/s}$$

Chaque bloc $x_k$ de N échantillons subit alors une transformée dans le domaine fréquentiel à dérive fréquentielle linéaire compensée, pour chaque valeur $\alpha_m$ de dérive fréquentielle linéaire considérée, afin de produire un spectrogramme S[m].

Un spectrogramme S[m] est une représentation bidimensionnelle temps / fréquence du signal global dans laquelle une dérive fréquentielle linéaire de valeur $\alpha_m$ a été compensée. En d'autres termes, le spectrogramme S[m] pour la valeur $\alpha_m$ de dérive fréquentielle linéaire est constitué de KxN valeurs S[k,n,m] associées respectivement à différents instants d'analyse k $(0 \leq k \leq K-1)$ et différentes fréquences d'analyse n $(0 \leq n \leq N-1)$ à l'intérieur de la bande fréquentielle de multiplexage. Par exemple, la valeur S[k,n,m] est calculée selon l'expression suivante :

$$S[k,n,m] = \frac{1}{N} \cdot \left| F(x_k, \alpha_m)[n] \right|^2$$

expression dans laquelle $F(x_k, \alpha_m)[n]$ correspond à la valeur, à la fréquence d'analyse n, de la transformée F dans le domaine fréquentiel du bloc $x_k$ en compensant une dérive fréquentielle linéaire de valeur $\alpha_m$.

Plusieurs expressions de la transformée F dans le domaine fréquentiel à dérive fréquentielle linéaire compensée sont possibles.

Suivant un premier exemple, la transformée $F(x_k, \alpha_m)$ dans le domaine fréquentiel à dérive fréquentielle linéaire compensée correspond à une transformée de Fourier fractionnaire du bloc $x_k$, d'angle correspondant à la valeur $\alpha_m$ de dérive fréquentielle considérée :

$$F(x_k, \alpha_m)[n] = FrFT\left(x_k, \tan^{-1}(\alpha_m)\right)[n]$$

avec :

$$FrFT(x, \theta)[u] = \sqrt{1 - j \cdot \cot(\theta)} \cdot e^{j \cdot \pi \cdot \cot(\theta) \cdot u^2} \cdot \int_{-\infty}^{\infty} e^{-j \cdot 2\pi \cdot \left( \csc(\theta) \cdot u \cdot x - \frac{\cot(\theta)}{2} \cdot x^2 \right)} \cdot f(x) \cdot dx$$

expression dans laquelle :

- j est l'unité imaginaire ($j^2 = -1$),
- $\cot(\theta)$ est la fonction cotangente de l'angle $\theta$,
- $\csc(\theta)$ est la fonction cosécante de l'angle $\theta$,
- $e^{(y)}$ est la fonction exponentielle de la valeur y.

Suivant un second exemple, la transformée $F(x_k, \alpha_m)$ dans le domaine fréquentiel à dérive fréquentielle linéaire compensée comporte une compensation préalable de la dérive fréquentielle linéaire de valeur $\alpha_m$ sur le bloc $x_k$, et un calcul de transformée de Fourier du bloc obtenu après compensation. Par exemple, la compensation est effectuée par multiplication du bloc $x_k$ par un chirp de dérive fréquentielle linéaire égale à ($-\alpha_m$), auquel cas on obtient un bloc $x_{k,m}$ après compensation égal à :

$$x_{k,m} = \left\{ x_k[n + k \cdot N] \cdot e^{-j \cdot \pi \cdot \alpha_m \cdot (n \cdot Te + k \cdot N \cdot Te - t_0)^2}, 0 \leq n \leq N - 1 \right\}, 0 \leq k \leq K\text{-}1$$

expression dans laquelle $t_0$ correspond à un premier instant d'échantillonnage de la fenêtre temporelle d'analyse, puis on calcule la transformée de Fourier du bloc $x_{k,m}$ :

$$F(x_k, \alpha_m)[n] = FFT(x_{k,m})[n]$$

Suivant un troisième exemple non limitatif, la transformée $F(x_k, \alpha_m)$ dans le domaine fréquentiel à dérive fréquentielle linéaire compensée comporte un calcul de transformée de Fourier du bloc $x_k$, et une compensation de dérive fréquentielle sur le spectre fréquentiel obtenu pour le bloc $x_k$, en l'occurrence par une translation dans le domaine fréquentiel :

$$F(x_k, \alpha_m)[n] = FFT(x_k)\left[n - \alpha_m \cdot k \cdot N^2 \cdot Te^2\right]$$

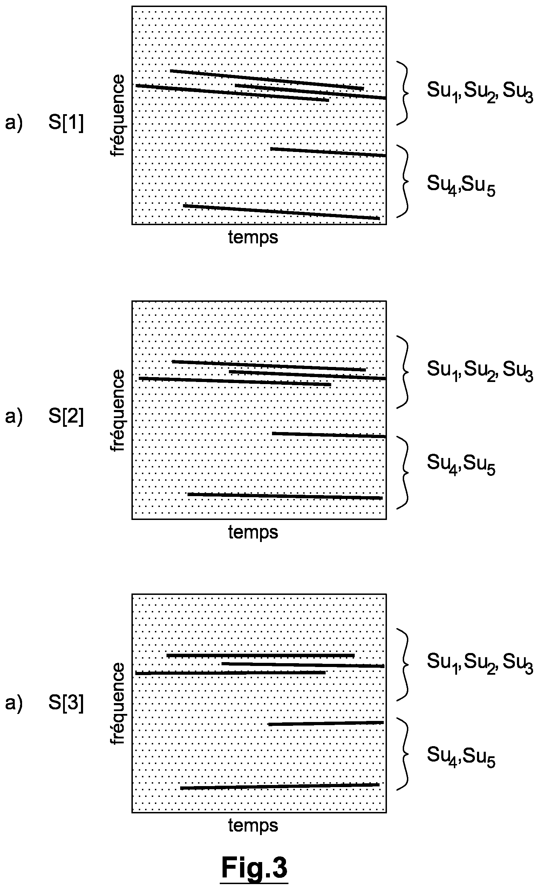

La figure 3 représente des exemples de spectrogrammes obtenus pour un même signal global, comportant essentiellement cinq signaux utiles $Su_1$, $Su_2$, $Su_3$, $Su_4$ et $Su_5$. Plus particulièrement :

- la partie a) représente un spectrogramme S[1] obtenu pour une valeur $\alpha_1$ égale à 0 Hz/s,
- la partie b) représente un spectrogramme S[2] obtenu pour une valeur $\alpha_2$ égale à -250 Hz/s,
- la partie a) représente un spectrogramme S[3] obtenu pour une valeur $\alpha_3$ égale à -450 Hz/s,

Tel qu'illustré par la partie a) de la figure 3, les signaux utiles $Su_1$ à $Su_5$ présentent tous un biais fréquentiel non nul, de sorte que le spectrogramme S[1] ne permet en principe de détecter aucun signal utile.

Tel qu'illustré par la partie b) de la figure 3, les signaux utiles $Su_4$ et $Su_5$ présentent un biais fréquentiel sensiblement linéaire et égal à -250 Hz/s, de sorte qu'ils sont sensiblement dépourvus de dérive fréquentielle dans le spectrogramme S[2] et pourront y être détectés.

Tel qu'illustré par la partie c) de la figure 3, les signaux utiles $Su_1$, $Su_2$ et $Su_3$ présentent un biais fréquentiel sensiblement linéaire et égal à -450 Hz/s, de sorte qu'ils sont sensiblement dépourvus de dérive fréquentielle dans le spectrogramme S[3] et pourront y être détectés.

Les différents spectrogrammes S[m] sont ensuite filtrés, au cours de l'étape 52 de filtrage d'enveloppe temporelle. Plus particulièrement, pour chaque spectrogramme et chaque fréquence d'analyse, les valeurs aux différents instants d'analyse sont filtrées suivant l'axe temporel au moyen d'un filtre représentatif d'une enveloppe temporelle de référence des signaux utiles. En d'autres termes, le filtre utilisé est un filtre adapté à l'enveloppe temporelle des signaux utiles.

L'étape 52 de filtrage d'enveloppe temporelle des différentes valeurs du spectrogramme suivant l'axe temporel vise à améliorer, en chaque instant d'analyse, le rapport signal sur bruit d'un éventuel signal utile dépourvu de dérive fréquentielle en tenant compte d'une connaissance a priori sur l'enveloppe temporelle des signaux utiles. Par exemple, le filtre représentatif de l'enveloppe temporelle de référence correspond à une fenêtre dont la durée est égale à la durée des signaux utiles, si les signaux utiles ont tous la même durée. Si les signaux utiles n'ont pas tous la même durée et/ou s'ils sont de durée variable, alors la durée de ladite fenêtre correspond par exemple à la durée minimale desdits signaux utiles. Dans le cas où plusieurs durées sont possibles pour les signaux utiles, il est également possible de considérer différents filtres adaptés aux différentes durées desdits signaux utiles.

Dans le cas où le signal utile est sensiblement à amplitude constante, alors le filtrage d'enveloppe temporelle peut consister en un simple calcul de somme glissante ou de moyenne glissante suivant l'axe temporel (addition / soustraction de la valeur la plus récente / ancienne).

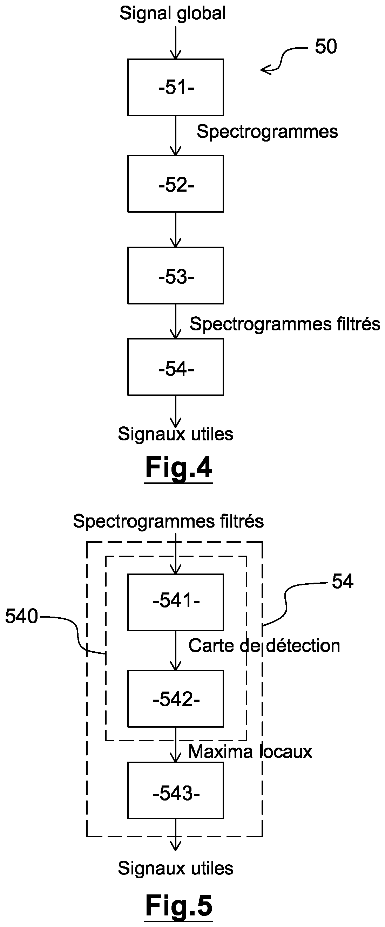

La figure 4 représente schématiquement un mode particulier de mise en oeuvre, dans lequel le procédé 50 de détection comporte en outre une étape 53 de filtrage de spectre fréquentiel. Plus particulièrement, pour chaque spectrogramme et chaque instant d'analyse, les valeurs aux différentes fréquences d'analyse sont filtrées suivant l'axe fréquentiel au moyen d'un filtre représentatif d'un spectre fréquentiel de référence des signaux utiles. En d'autres termes, le filtre utilisé est un filtre adapté au spectre fréquentiel des signaux utiles.

Comme pour l'étape 52 de filtrage d'enveloppe temporelle, l'étape 53 de filtrage de spectre fréquentiel vise à améliorer, en chaque fréquence d'analyse, le rapport signal sur bruit d'un éventuel signal utile dépourvu de dérive fréquentielle. Cette amélioration est obtenue par la prise en compte d'une connaissance a priori sur le spectre fréquentiel desdits signaux utiles, par exemple sur la largeur spectrale desdits signaux utiles ou la largeur spectrale minimale desdits signaux utiles s'ils n'ont pas la même largeur spectrale et/ou s'ils sont de largeur spectrale variable. Dans le cas où plusieurs largeurs spectrales sont possibles pour les signaux utiles, il est également possible de considérer différents filtres adaptés aux différentes largeurs spectrales desdits signaux utiles. La forme générale du spectre fréquentiel des signaux utiles peut également être prise en compte dans le spectre fréquentiel de référence.

Dans la suite de la description, on considère de manière non limitative le cas où tous les signaux utiles ont sensiblement la même durée et le même spectre fréquentiel. La durée de la fenêtre temporelle d'analyse est choisie supérieure à la durée des signaux utiles.

L'étape 52 de filtrage d'enveloppe temporelle et l'étape 53 de filtrage de spectre fréquentiel peuvent être exécutées dans un ordre quelconque. Lesdites étapes peuvent également être exécutées conjointement, par exemple par une convolution 2D au moyen d'un noyau de convolution $K_C$ qui correspond, sur l'axe temporel, à un filtre adapté à l'enveloppe temporelle des signaux utiles et, sur l'axe fréquentiel, à un filtre adapté au spectre fréquentiel desdits signaux utiles. Le cas échéant, le spectrogramme filtré SF[m] est par exemple calculé selon l'expression suivante :

$$SF[k,n,m] = \sum_u \sum_v K_C[u,v] \cdot S[k-u, n-v, m]$$

Tel qu'illustré par les figures 2 et 4, le procédé 50 de détection comporte également une étape 54 de recherche de signaux utiles dans les spectrogrammes filtrés SF[m] obtenus par filtrage d'enveloppe temporelle et, le cas échéant, par filtrage de spectre fréquentiel.

En pratique, un signal utile est détecté à un instant d'analyse k et une fréquence d'analyse n si un critère prédéfini de détection est vérifié par la valeur SF[k,n,m] d'un spectrogramme filtré SF[m].

Si l'on considère que l'on dispose d'un nombre M de spectrogrammes filtrés SF[m] (1 ≤ m ≤ M), alors cela peut faire théoriquement KxNxM valeurs à tester en tout pour une fenêtre temporelle d'analyse donnée, si l'on évalue le critère de détection pour chaque valeur de chaque spectrogramme filtré.

La figure 5 représente schématiquement un mode particulier de mise en oeuvre de l'étape 54 de recherche de signaux utiles dans les spectrogrammes filtrés, dans lequel le critère de détection est évalué uniquement pour des valeurs qui correspondent à des maxima locaux sur un ensemble à trois dimensions constitué par les valeurs des différents spectrogrammes filtrés.

L'étape 54 de recherche de signaux utiles comporte à cet effet, et tel qu'illustré par la figure 5, une étape 540 de recherche de maxima locaux dans l'ensemble à trois dimensions constitué par les valeurs des différents spectrogrammes filtrés, et une étape 543 d'évaluation du critère de détection uniquement pour des valeurs qui correspondent à des maxima locaux dudit ensemble à trois dimensions.

Ainsi, le nombre de valeurs pour lesquelles le critère de détection doit être évalué est réduit. En outre, du fait que la recherche de maxima locaux est effectuée sur un ensemble à trois dimensions, un même signal utile correspondra à un seul maximum local (dans le spectrogramme filtré dont la dérive fréquentielle linéaire est la plus proche de celle du signal utile, ce qui permet en outre d'estimer la dérive fréquentielle linéaire dudit signal utile).

En effectuant une recherche de maxima locaux dans chaque spectrogramme filtré (c'est-à-dire en effectuant M recherches de maxima locaux sur des ensembles à deux dimensions), un même signal utile pourrait correspondre à plusieurs maxima locaux identifiés dans des spectrogrammes filtrés différents. Par conséquent, le fait d'effectuer une recherche dans un ensemble à trois dimensions (plutôt que d'effectuer M recherches de maxima locaux sur des ensembles à deux dimensions) permet d'éviter les détections multiples d'un même signal utile.

Toutefois, la recherche de maxima locaux dans un ensemble à trois dimensions de KxNxM valeurs peut également nécessiter une capacité de calcul importante.

Pour réduire davantage la capacité de calcul nécessaire, l'étape 540 de recherche de maxima locaux comporte, dans un mode préféré de mise en oeuvre également illustré par la figure 5 :

- une étape 541 d'établissement d'une carte de détection associant, à chaque fréquence d'analyse et chaque spectrogramme filtré, la valeur maximale dudit spectrogramme filtré à ladite fréquence d'analyse sur les différents instants d'analyse de la fenêtre temporelle d'analyse,
- une étape 542 de recherche de maxima locaux de ladite carte de détection (le critère de détection étant évalué, au cours de l'étape 543, pour des valeurs correspondant à des maxima locaux de ladite carte de détection).

Ainsi, le mode préféré de mise en oeuvre illustré par la figure 5 repose sur l'établissement d'une carte de détection à deux dimensions à partir de l'ensemble des KxNxM valeurs SF[k,n,m] d'un ensemble à trois dimensions.

En effet, suivant l'axe temporel, seules les valeurs maximales des spectrogrammes filtrés SF[m] sur la fenêtre temporelle d'analyse considérée sont conservées. On passe ainsi d'un ensemble à trois dimensions (temps / fréquence / dérive fréquentielle linéaire) à un ensemble à deux dimensions (fréquence / dérive fréquentielle linéaire) dans lequel la carte de détection reprend, pour chaque paire (fréquence d'analyse / dérive fréquentielle linéaire), la valeur maximale obtenue sur la fenêtre temporelle d'analyse considérée. La complexité de calcul est donc réduite grâce au fait que la recherche de maxima locaux est réalisée dans un ensemble à deux dimensions, et non plus dans un ensemble à trois dimensions.

La complexité de calcul est réduite en considérant que l'on peut détecter, pour chaque paire (fréquence d'analyse / dérive fréquentielle linéaire), au plus un signal utile sur la fenêtre temporelle d'analyse considérée. Pour détecter des signaux utiles émis à des instants différents pour une même paire (fréquence d'analyse / dérive fréquentielle linéaire), les différentes étapes du procédé 50 de détection peuvent être itérées pour des fenêtres temporelles d'analyse successives. De préférence, la durée des fenêtres temporelles d'analyse est choisie supérieure à la durée des signaux utiles et inférieure à deux fois ladite durée desdits signaux utiles, et présentent un recouvrement temporel non nul, afin d'éviter de rater un signal utile qui serait à cheval sur deux fenêtres temporelles d'analyse avec un recouvrement temporel nul. Par exemple, deux fenêtres temporelles d'analyse adjacentes présentent un recouvrement temporel compris entre 10% et 50% de la durée des fenêtres temporelles d'analyse, de préférence compris entre 20% et 40%.

La carte de détection $D_{2D}$ est par exemple déterminée, pour une fenêtre temporelle d'analyse $F_A$ comportant K instants d'analyse k, selon l'expression suivante :

$$D_{2D}[n,m] = \max_{k \in F_A}(SF[k,n,m])$$

De préférence, l'instant d'analyse $k^{MAX}[n,m]$ de chaque valeur maximale $D_{2D}[n,m]$ est également déterminé :

$$k^{MAX}[n,m] = \underset{k \in F_A}{\arg\max}(SF[k,n,m])$$

Ensuite, on recherche les maxima locaux de la carte de détection $D_{2D}$, selon toute méthode connue de l'homme du métier, et on évalue le critère de détection pour chaque maximum local de ladite carte de détection $D_{2D}$. De manière générale, différents critères de détection peuvent être considérés.

Par exemple, le critère de détection peut être vérifié pour un maximum local de la carte de détection $D_{2D}$ si la valeur dudit maximum local est supérieure à une valeur seuil prédéfinie. De manière conventionnelle, la valeur seuil prédéfinie est par exemple calculée en fonction d'une probabilité de fausse alarme et d'une probabilité de détection souhaitées.

Afin notamment de réduire encore la probabilité de fausse alarme, il est également possible de considérer le critère de détection comme étant vérifié uniquement si le maximum local considéré est en outre la valeur maximale sur une fenêtre fréquentielle de détection prédéfinie autour de la fréquence d'analyse à laquelle ledit maximum local a été identifié. En d'autres termes, le critère de détection ne peut pas être vérifié pour deux maxima locaux trop proches en fréquences. La largeur de la fenêtre fréquentielle de détection, par exemple centrée sur la fréquence d'analyse à laquelle le maximum local a été identifié, est par exemple déterminée en fonction de la résolution fréquentielle des fréquences d'analyse et de la résolution fréquentielle des dérives fréquentielles linéaires considérées.

Il est également possible de considérer le critère de détection comme étant vérifié uniquement si l'instant d'analyse auquel le maximum local considéré a été identifié se trouve dans une portion centrale prédéfinie de la fenêtre temporelle d'analyse considérée. En effet, dans un tel cas, on assure que tout le signal utile détecté se trouve dans la fenêtre temporelle d'analyse considérée. Si l'instant d'analyse auquel le maximum local considéré a été identifié ne se trouve pas dans ladite portion centrale prédéfinie, et s'il correspond à un signal utile, ledit signal utile pourra toujours être détecté dans une autre fenêtre temporelle d'analyse, grâce au recouvrement temporel.

A l'issue de l'étape 543 d'évaluation du critère de détection, on dispose donc d'un ensemble de maxima locaux pour lesquels ledit critère de détection a été vérifié, considérés comme correspondant à des signaux utiles détectés dans le signal global. Les coordonnées des maxima locaux permettent en outre de fournir une première estimation des paramètres physiques desdits signaux utiles (instant d'émission, fréquence initiale, dérive fréquentielle). C'est un objectif de l'invention que de pouvoir déterminer, pour chaque signal utile détecté, une première estimation de ces paramètres (instant d'émission, fréquence initiale, dérive fréquentielle), afin de pouvoir ensuite les fournir en entrée à d'autres méthodes aptes à augmenter la précision de la détection au niveau de chaque signal utile.

De manière plus générale, il est à noter que les modes de mise en oeuvre et de réalisation considérés ci-dessus ont été décrits à titre d'exemples non limitatifs, et que d'autres variantes sont par conséquent envisageables.

Notamment, l'invention a été décrite en considérant une seule station de réception. Rien n'exclut cependant, suivant d'autres exemples, de considérer un système de détection comportant plusieurs stations de réception 20. Il est alors possible d'effectuer de la diversité en réception en fusionnant, par exemple dans une station sol, des ensembles de signaux globaux reçus et/ou de signaux utiles détectés par chacune des stations de réception du système de détection. Cette fusion nécessite de synchroniser en temps, fréquence et phase les acquisitions réalisées par les différentes stations de réception. Cette synchronisation peut être réalisée à l'aide d'équipements dédiés (référence de temps), de signaux de calibration ou de signaux utiles opportunistes reçus simultanément par au moins deux stations de réception.

**Revendications**

1. Procédé (50) de détection d'une pluralité de signaux utiles dans un signal global, chaque signal utile étant de durée finie et pouvant être affecté d'une dérive fréquentielle supérieure, sur la durée dudit signal utile, à une largeur spectrale dudit signal utile, lesdits signaux utiles correspondant à des signaux radioélectriques émis par différents terminaux (10) dans une bande fréquentielle de multiplexage, ledit signal global correspondant à l'ensemble des signaux radioélectriques reçus dans la bande fréquentielle de multiplexage, **caractérisé en ce qu'**il comporte des étapes :

   - (51) calcul de plusieurs spectrogrammes associés respectivement à différentes valeurs de dérive fréquentielle linéaire, chaque spectrogramme étant représentatif des valeurs du spectre fréquentiel du signal global à différentes fréquences d'analyse dans la bande fréquentielle de multiplexage, et des évolutions dans le temps desdites valeurs du spectre fréquentiel à différents instants d'analyse à l'intérieur d'une fenêtre temporelle d'analyse en compensant la dérive fréquentielle linéaire considérée,
   - pour chaque fréquence d'analyse et chaque spectrogramme : (52) filtrage d'enveloppe temporelle des valeurs aux différents instants d'analyse dudit spectrogramme à ladite fréquence d'analyse, au moyen d'un filtre représentatif d'une enveloppe temporelle de référence des signaux utiles,

un signal utile étant détecté à un instant d'analyse et une fréquence d'analyse si un critère prédéfini de détection est vérifié par la valeur d'un spectrogramme obtenu par filtrage, dit « spectrogramme filtré », pour ledit instant d'analyse et ladite fréquence d'analyse.

2. Procédé (50) selon la revendication 1, comportant, pour chaque instant d'analyse et chaque spectrogramme, une étape (53) de filtrage de spectre fréquentiel des valeurs aux différentes fréquences d'analyse dudit spectrogramme audit instant d'analyse, au moyen d'un filtre représentatif d'un spectre fréquentiel de référence des signaux utiles.

3. Procédé (50) selon l'une des revendications précédentes, dans lequel l'étape (52) de filtrage d'enveloppe temporelle et l'étape (53) de filtrage de spectre fréquentiel sont exécutées conjointement.

4. Procédé (50) selon l'une des revendications précédentes, comportant une étape (540) de recherche de maxima locaux sur un ensemble à trois dimensions constitué par les valeurs des différents spectrogrammes filtrés, le critère de détection étant évalué (543) pour des valeurs correspondant à des maxima locaux dudit ensemble.

5. Procédé (50) selon la revendication 4, dans lequel l'étape (540) de recherche de maxima locaux comporte :

- (541) l'établissement d'une carte de détection associant, à chaque fréquence d'analyse et chaque spectrogramme filtré, la valeur maximale dudit spectrogramme filtré à ladite fréquence d'analyse sur les instants d'analyse de la fenêtre temporelle d'analyse,
- (542) la recherche de maxima locaux de ladite carte de détection, le critère de détection étant évalué pour des valeurs correspondant à des maxima locaux de ladite carte de détection.

6. Procédé (50) selon l'une des revendications précédentes, dans lequel le critère de détection est vérifié pour une valeur d'un spectrogramme filtré si ladite valeur est supérieure à une valeur seuil prédéfinie.

7. Procédé (50) selon la revendication 6, dans lequel le critère de détection est vérifié pour une valeur d'un spectrogramme filtré si ladite valeur est une valeur maximale sur une fenêtre fréquentielle de détection prédéfinie autour de la fréquence d'analyse à laquelle ladite valeur a été obtenue.

8. Procédé (50) selon l'une des revendications 6 à 7, dans lequel le critère de détection est vérifié pour une valeur d'un spectrogramme filtré si l'instant d'analyse auquel ladite valeur a été obtenue se trouve dans une portion centrale prédéfinie de la fenêtre temporelle d'analyse.

9. Procédé (50) selon l'une des revendications précédentes, dans lequel le calcul d'un spectrogramme associé à une valeur de dérive fréquentielle linéaire comporte des calculs de transformée de Fourier fractionnaire de blocs successifs du signal global, d'angle correspondant à ladite dérive fréquentielle linéaire considérée.

10. Procédé (50) selon l'une des revendications 1 à 8, dans lequel le calcul d'un spectrogramme associé à une valeur de dérive fréquentielle linéaire comporte une compensation préalable de la dérive fréquentielle linéaire considérée sur le signal global, et des calculs de transformée de Fourier de blocs successifs du signal global obtenu après compensation.

11. Procédé (50) selon l'une des revendications 1 à 8, dans lequel le calcul d'un spectrogramme associé à une valeur de dérive fréquentielle linéaire comporte des calculs de transformée de Fourier de blocs successifs du signal global, et une compensation de la dérive fréquentielle linéaire considérée sur les spectres fréquentiels des blocs successifs.

12. Procédé (50) selon l'une des revendications précédentes, dans lequel les étapes dudit procédé sont itérées pour des fenêtres temporelles d'analyse successives présentant un recouvrement temporel non nul.

13. Produit programme d'ordinateur **caractérisé en ce qu'**il comporte un ensemble d'instructions de code de programme qui, lorsqu'elles sont exécutées par un processeur, configurent ledit processeur pour mettre en oeuvre un procédé (50) de détection de signaux utiles dans un signal global selon l'une des revendications précédentes.

14. Module (40) de détection de signaux utiles dans un signal global **caractérisé en ce qu'**il comporte des moyens configurés pour mettre en oeuvre un procédé (50) selon l'une des revendications 1 à 12.

**15.** Système de détection de signaux utiles dans un signal global, comportant une antenne de réception du signal global embarquée dans un engin spatial (30) ou aérien, **caractérisé en ce qu'**il comporte un module (40) de détection selon la revendication 14.

**Patentansprüche**

**1.** Verfahren (50) zum Detektieren einer Vielzahl von Nutzsignalen in einem Gesamtsignal, wobei jedes Nutzsignal von endlicher Dauer ist und von einer Frequenzabweichung betroffen sein kann, die über die Dauer des Nutzsignals größer ist als eine spektrale Breite des Nutzsignals, wobei die Nutzsignale Funksignale entsprechen, die von verschiedenen Endgeräten (10) in einem Multiplexing-Frequenzband gesendet werden, wobei das Gesamtsignal der Gesamtheit der im Multiplexing-Frequenzband empfangenen Funksignale entspricht, **dadurch gekennzeichnet, dass** es Schritte umfasst:

- (51) Berechnen von mehreren Spektrogrammen, die jeweils verschiedenen linearen Frequenzabweichungswerten zugeordnet sind, wobei jedes Spektrogramm für die Werte des Frequenzspektrums des Gesamtsignals auf verschiedenen Analysefrequenzen im Multiplexing-Frequenzband, und für die zeitlichen Entwicklungen der Werte des Frequenzspektrums zu verschiedenen Analysezeitpunkten innerhalb eines Analysezeitfensters unter Kompensation der betreffenden linearen Frequenzabweichung repräsentativ ist,
- für jede Analysefrequenz und jedes Spektrogramm: (52) Zeithüllkurven-Filterung der Werte zu den verschiedenen Analysezeitpunkten des Spektrogramms auf der Analysefrequenz mittels eines Filters, der für eine Referenz-Zeithüllkurve der Nutzsignale repräsentativ ist, wobei ein Nutzsignal zu einem Analysezeitpunkt und auf einer Analysefrequenz detektiert wird, wenn ein vordefiniertes Detektionskriterium durch den Wert eines durch Filterung erhaltenen Spektrogramms, "gefiltertes Spektrogramm" genannt, für den Analysezeitpunkt und die Analysefrequenz verifiziert wird.

**2.** Verfahren (50) nach Anspruch 1, das für jeden Analysezeitpunkt und jedes Spektrogramm einen Schritt (53) der Frequenzspektrums-Filterung der Werte auf den verschiedenen Analysefrequenzen des Spektrogramms zum Analysezeitpunkt mittels eines Filters umfasst, der für ein Referenz-Frequenzspektrum der Nutzsignale repräsentativ ist.

**3.** Verfahren (50) nach einem der vorstehenden Ansprüche, wobei der Schritt (52) der Zeithüllkurven-Filterung und der Schritt (53) der Frequenzspektrums-Filterung gemeinsam ausgeführt werden.

**4.** Verfahren (50) nach einem der vorstehenden Ansprüche, das einen Schritt (540) des Suchens von lokalen Maxima über eine Gesamtheit mit drei Dimensionen, die von den Werten der verschiedenen gefilterten Spektrogramme gebildet wird, umfasst, wobei das Detektionskriterium für Werte ausgewertet wird (543), die lokalen Maxima der Gesamtheit entsprechen.

**5.** Verfahren (50) nach Anspruch 4, wobei der Schritt (540) des Suchens von lokalen Maxima umfasst:

- (541) das Erstellen einer Detektionskarte, die jeder Analysefrequenz und jedem gefilterten Spektrogramm den Maximalwert des gefilterten Spektrogramms auf der Analysefrequenz über die Analysezeitpunkte des Analysezeitfensters zuordnet,
- (542) das Suchen von lokalen Maxima der Detektionskarte, wobei das Detektionskriterium für Werte ausgewertet wird, die lokalen Maxima der Detektionskarte entsprechen.

**6.** Verfahren (50) nach einem der vorstehenden Ansprüche, wobei das Detektionskriterium für einen Wert eines gefilterten Spektrogramms verifiziert wird, wenn der Wert größer ist als ein vordefinierter Schwellenwert.

**7.** Verfahren (50) nach Anspruch 6, wobei das Detektionskriterium für einen Wert eines gefilterten Spektrogramms verifiziert wird, wenn der Wert ein Maximalwert über ein vordefiniertes Detektionsfrequenzfenster um die Analysefrequenz herum ist, auf der der Wert erhalten wurde.

**8.** Verfahren (50) nach einem der Ansprüche 6 bis 7, wobei das Detektionskriterium für einen Wert eines gefilterten Spektrogramms verifiziert wird, wenn sich der Analysezeitpunkt, zu dem der Wert erhalten wurde, in einem vordefinierten zentralen Abschnitt des Analysezeitfensters befindet.

**9.** Verfahren (50) nach einem der vorstehenden Ansprüche, wobei das Berechnen eines Spektrogramms, das einem linearen Frequenzabweichungswert zugeordnet ist, fraktionale Fourier-Transformationsberechnungen von aufeinanderfolgenden Blöcken des Gesamtsignals mit einem Winkel umfasst, der der betreffenden linearen Frequenzabweichung entspricht.

10. Verfahren (50) nach einem der Ansprüche 1 bis 8, wobei das Berechnen eines Spektrogramms, das einem linearen Frequenzabweichungswert zugeordnet ist, eine vorhergehende Kompensation der betreffenden linearen Frequenzabweichung über das Gesamtsignal, und Fourier-Transformationsberechnungen von aufeinanderfolgenden Blöcken des nach Kompensation erhaltenen Gesamtsignals umfasst.

11. Verfahren (50) nach einem der Ansprüche 1 bis 8, wobei das Berechnen eines Spektrogramms, das einem linearen Frequenzabweichungswert zugeordnet ist, Fourier-Transformationsberechnungen von aufeinanderfolgenden Blöcken des Gesamtsignals, und eine Kompensation der betreffenden linearen Frequenzabweichung über die Frequenzspektren der aufeinanderfolgenden Blöcke umfasst.

12. Verfahren (50) nach einem der vorstehenden Ansprüche, wobei die Schritte des Verfahrens für aufeinanderfolgende Analysezeitfenster, die eine Zeitabdeckung von ungleich Null aufweisen, iteriert werden.

13. Computerprogrammprodukt, **dadurch gekennzeichnet, dass** es einen Satz von Programmcodeanweisungen umfasst, die, wenn sie von einem Prozessor ausgeführt werden, den Prozessor dafür konfigurieren, ein Verfahren (50) zum Detektieren von Nutzsignalen in einem Gesamtsignal nach einem der vorstehenden Ansprüche umzusetzen.

14. Modul (40) zum Detektieren von Nutzsignalen in einem Gesamtsignal, **dadurch gekennzeichnet, dass** es Mittel umfasst, die dafür konfiguriert sind, ein Verfahren (50) nach einem der Ansprüche 1 bis 12 umzusetzen.

15. System zum Detektieren von Nutzsignalen in einem Gesamtsignal, das eine Antenne zum Empfangen des Gesamtsignals umfasst, die in ein Raum- (30) oder Luftfahrzeug integriert ist, **dadurch gekennzeichnet, dass** es ein Detektionsmodul (40) nach Anspruch 14 umfasst.

## Claims

1. A method (50) for detecting a plurality of useful signals in a total signal, each useful signal being of finite duration and potentially being subject to a frequency drift that is greater, over the duration of said useful signal, than a spectral width of said useful signal, said useful signals corresponding to radiofrequency signals transmitted by various terminals (10) in a multiplexing frequency band, said total signal corresponding to all of the radiofrequency signals received in the multiplexing frequency band, **characterized in that** it includes steps:

   - (51) calculating multiple spectrograms associated with various linear frequency drift values, respectively, each spectrogram being representative of the values of the frequency spectrum of the total signal at various analysis frequencies in the multiplexing frequency band, and of time variations of said values of the frequency spectrum at various analysis times within an analysis time window by compensating for the linear frequency drift under consideration;
   - for each analysis frequency and each spectrogram: (52) time envelope filtering of the values at the various times of analysis of said spectrogram at said analysis frequency, by means of a filter representative of a reference time envelope of the useful signals,

   a useful signal being detected at an analysis time and an analysis frequency if a predefined detection criterion is verified by the value of a spectrogram obtained by filtering, referred to as a "filtered spectrogram", for said analysis time and said analysis frequency.

2. The method (50) as claimed in claim 1, including, for each analysis time and each spectrogram, a step (53) of filtering the frequency spectrum of the values at the various analysis frequencies of said spectrogram at said analysis time, by means of a filter representative of a reference frequency spectrum of the useful signals.

3. The method (50) as claimed in one of the preceding claims, in which the time envelope filtering step (52) and the frequency spectrum filtering step (53) are executed together.

4. The method (50) as claimed in one of the preceding claims, including a step (540) of searching for local maxima in a set with three dimensions that is made up of the values of the various filtered spectrograms, the detection criterion being evaluated (543) for values corresponding to local maxima of said set.

5. The method (50) as claimed in claim 4, in which the step (540) of searching for local maxima includes:

- (541) setting up a detection map associating, with each analysis frequency and each filtered spectrogram, the maximum value of said filtered spectrogram at said analysis frequency over the analysis times of the analysis time window;
- (542) searching for local maxima on said detection map, the detection criterion being evaluated for values corresponding to local maxima on said detection map.

6. The method (50) as claimed in one of the preceding claims, in which the detection criterion is verified for a value of a filtered spectrogram if said value is higher than a predefined threshold value.

7. The method (50) as claimed in claim 6, in which the detection criterion is verified for a value of a filtered spectrogram if said value is a maximum value over a predefined frequency detection window around the analysis frequency at which said value has been obtained.

8. The method (50) as claimed in one of claims 6 to 7, in which the detection criterion is verified for a value of a filtered spectrogram if the analysis time at which said value has been obtained is located in a predefined central portion of the analysis time window.

9. The method (50) as claimed in one of the preceding claims, in which the calculation of a spectrogram associated with a linear frequency drift value includes fractional Fourier transform calculations of successive blocks of the total signal, the angle of which corresponds to said linear frequency drift under consideration.

10. The method (50) as claimed in one of claims 1 to 8, in which the calculation of a spectrogram associated with a linear frequency drift value includes prior compensation for the linear frequency drift under consideration on the total signal, and Fourier transform calculations of successive blocks of the total signal obtained after compensation.

11. The method (50) as claimed in one of claims 1 to 8, in which the calculation of a spectrogram associated with a linear frequency drift value includes Fourier transform calculations of successive blocks of the total signal, and compensation for the linear frequency drift under consideration on the frequency spectra of the successive blocks.

12. The method (50) as claimed in one of the preceding claims, in which the steps of said method are iterated for successive analysis time windows exhibiting non-zero temporal coverage.

13. A computer program product, **characterized in that** it includes a set of program code instructions that, when executed by a processor, configure said processor to implement a method (50) for detecting useful signals in a total signal as claimed in one of the preceding claims.

14. A module (40) for detecting useful signals in a total signal, **characterized in that** it includes means configured to implement a method (50) as claimed in one of claims 1 to 12.

15. A system for detecting useful signals in a total signal, including an antenna for receiving the total signal, which antenna is installed on board a spacecraft (30) or aircraft, **characterized in that** it includes a detection module (40) as claimed in claim 14.

**Fig.1**

Signal global

-51-

Spectrogrammes

-52-

Spectrogrammes filtrés

-54-

Signaux utiles

**Fig.2**

a)    S[1]

$Su_1, Su_2, Su_3$

$Su_4, Su_5$

fréquence

temps

a)    S[2]

$Su_1, Su_2, Su_3$

$Su_4, Su_5$

fréquence

temps

a)    S[3]

$Su_1, Su_2, Su_3$

$Su_4, Su_5$

fréquence

temps

**Fig.3**

Signal global

-51-

Spectrogrammes

-52-

-53-

Spectrogrammes filtrés

-54-

Signaux utiles

**Fig.4**

Spectrogrammes filtrés

-541-

Carte de détection

-542-

Maxima locaux

-543-

Signaux utiles

**Fig.5**

**EP 3 259 606 B1**

**Documents brevets cités dans la description**

- WO 2014006351 A1

- US 7787846 B1